# EUROPEAN PATENT APPLICATION

(11) **EP 4 475 634 A1**
(43) Date of publication of application: **11.12.2024**
(21) Application number: 23747027.3
(22) Date of filing: 26.01.2023
(51) Int. Cl.: H05K 1/14, H01L 23/02, H05K 1/02, H05K 1/11

(54) **COMPOSITE WIRING BOARD, ELECTRONIC COMPONENT STORAGE PACKAGE, AND ELECTRONIC DEVICE**

(30) Priority: 31.01.2022 JP 2022012614
(71) Applicant: Kyocera Corporation, Kyoto-shi, Kyoto 612-8501 (JP)
(72) Inventor: KAWAZU Yoshiki, Kyoto-shi, Kyoto 612-8501 (JP)
(74) Representative: Viering, Jentschura & Partner mbB Patent- und Rechtsanwälte
(86) International application number: PCT/JP2023/002420
(87) International publication number: WO 2023/145817

(57) **Abstract**

A composite wiring board includes a wiring board including a first joint region, and a flexible substrate including a second joint region overlapped with the first joint region. The wiring board includes a first signal line and a cutout disposed adjacent to the first signal line. The flexible substrate includes a second signal line to be joined to the first signal line, and a slit disposed adjacent to the second signal line. The cutout is positioned in the first joint region in a plan perspective view, and the slit is positioned in the second joint region in a plan perspective view.

## Description

### TECHNICAL FIELD

The present disclosure relates to a composite wiring board, an electronic component accommodating package, and an electronic device.

### BACKGROUND OF INVENTION

WO 2019/050046 A discloses a structure for connection between an electronic component accommodating package and a flexible substrate.

### SUMMARY

### SOLUTION TO PROBLEM

According to the present disclosure, a composite wiring board includes a wiring board, and a flexible substrate. The wiring board includes a first joint region. The flexible substrate includes a second joint region overlapped with the first joint region. The wiring board includes a first signal line, and a cutout disposed adjacent to the first signal line. The flexible substrate includes a second signal line to be joined to the first signal line, and a slit disposed adjacent to the second signal line. The cutout is positioned in the first joint region in a plan perspective view. The slit is positioned in the second joint region in a plan perspective view.

According to the present disclosure, an electronic component accommodating package includes the composite wiring board and a frame positioned on the wiring board.

According to the present disclosure, an electronic device includes the electronic component accommodating package and an electronic component positioned inside the frame.

### BRIEF DESCRIPTION OF THE DRAWINGS

FIG. 1A is a perspective view illustrating a principal part of a composite wiring board according to embodiment 1 of the present disclosure.
FIG. 1B is a rear-side perspective view illustrating the principal part of the composite wiring board according to embodiment 1 of the present disclosure.
FIG. 2A is a front-side plan view illustrating a principal part of a flexible substrate.
FIG. 2B is a rear-side plan view illustrating the principal part of the flexible substrate.
FIG. 3 is a plan view illustrating a principal part of a wiring board.
FIG. 4A is a longitudinal sectional view illustrating a joint portion of signal lines and the periphery of the joint portion.
FIG. 4B is a plan view illustrating the joint portion of the signal lines and the periphery of the joint portion.
FIG. 5A is a sectional view taken along line A-A in FIG. 4B and explanatorily indicating widths of respective portions.
FIG. 5B is a sectional view taken along line A-A in FIG. 4B and explanatorily illustrating a superimposed region.
FIG. 6A is a graph indicating frequency characteristics of composite wiring boards according to embodiment 1 and a comparative example.
FIG. 6B is a graph indicating impedance characteristics of the composite wiring boards according to embodiment 1 and the comparative example.
FIG. 7 is a sectional view of a composite wiring board according to embodiment 2.
FIG. 8 is a sectional view of a composite wiring board according to embodiment 3.
FIG. 9 is a perspective view of a composite wiring board according to embodiment 4.
FIG. 10A is a view of a slit according to embodiments 1 to 4.
FIG. 10B is a view of slits according to variation 1.
FIG. 10C is a view of a slit according to variation 2.
FIG. 10D is a view of a slit according to variation 3.
FIG. 10E is a view of slits according to variation 4.
FIG. 10F is a view of slits according to variation 5.
FIG. 10G is a view of slits according to variation 6.
FIG. 11A is a longitudinal sectional view of a cutout according to variation 7 provided in the wiring board.
FIG. 11B is a longitudinal sectional view of a cutout according to variation 8 provided in the wiring board.
FIG. 11C is a longitudinal sectional view of a cutout according to variation 9 provided in the wiring board.
FIG. 12 is a perspective view of an electronic component accommodating package and an electronic device according to an embodiment of the present disclosure.
FIG. 13 is a perspective view of another exemplary electronic component accommodating package according to an embodiment of the present disclosure.

### DESCRIPTION OF EMBODIMENTS

Embodiments of the present disclosure will be described in detail hereinafter with reference to the drawings.

### (Embodiment 1)

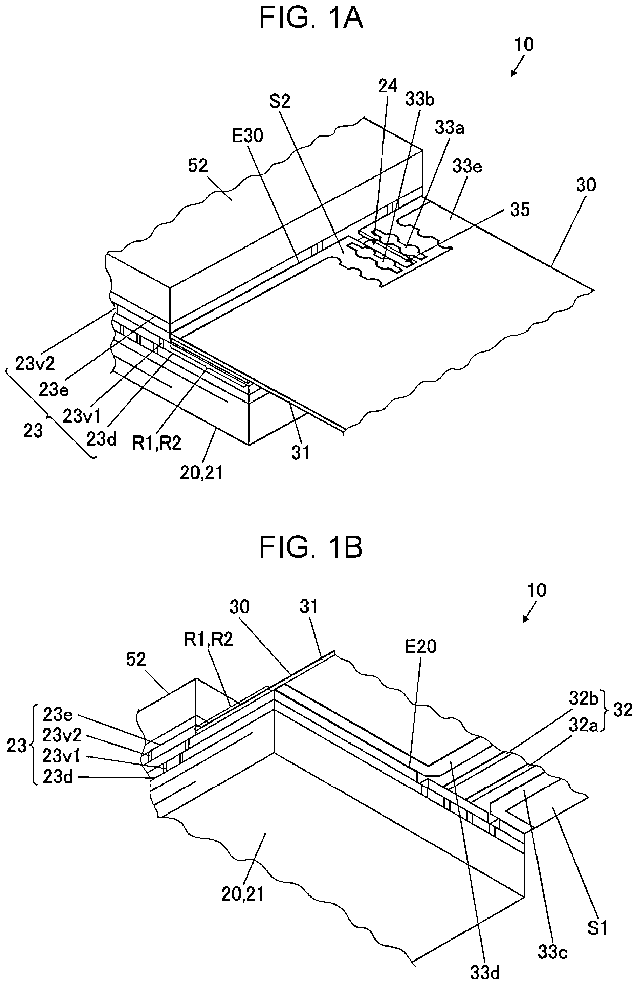

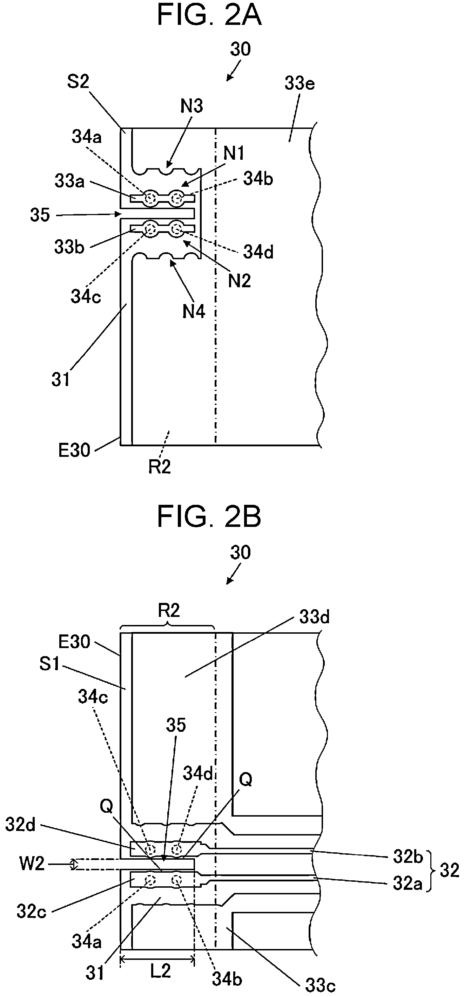

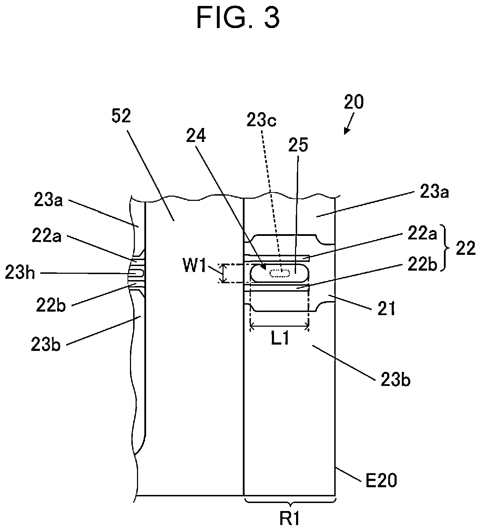

FIG. 1A is a perspective view illustrating a principal part of a composite wiring board according to embodiment 1 of the present disclosure. FIG. 1B is a rear-side perspective view illustrating the principal part of the composite wiring board according to embodiment 1 of the present disclosure. FIGs. 2A and 2B are a front-side plan view and a rear-side plan view each illustrating a principal part of a flexible substrate. FIG. 3 is a plan view illustrating a principal part of a wiring board.

Embodiment 1 provides a composite wiring board 10 including a wiring board 20 and a flexible substrate 30.

### <Wiring board>

The wiring board 20 includes an insulating substrate 21, a first signal line 22 positioned on the insulating substrate 21, and a recess 24 provided as a cutout.

The recess 24 is disposed adjacent to the first signal line 22. The first signal line 22 and the recess 24 adjacent to each other are aligned in a line width direction of the first signal line 22, a line direction, or in a direction slanted from the line width direction. When the first signal line 22 and the recess 24 are disposed adjacent to each other, a center line in the line direction of the first signal line 22 and a center line in a longitudinal direction of the recess 24 may be parallel or nonparallel to each other. The recess 24 may be positioned around the first signal line 22. Being positioned around the first signal line 22 can mean being positioned close enough to influence transmission characteristics of the first signal line 22, and can mean that distance from the first signal line 22 is twice or less a line width of the first signal line 22.

The wiring board 20 may further include a ground conductor 23 positioned on the insulating substrate 21.

The insulating substrate 21 may be made of a ceramic or a resin. FIGs. 1 to 5 exemplarily illustrate the wiring board 20 integrated with a frame 52. Alternatively, the frame 52 may be removed. The insulating substrate 21 may have a plate shape without the frame 52. The frame 52 may be formed integrally with the wiring board 20, or may be formed separately and joined to the wiring board 20. The insulating substrate 21 and the frame 52 may interpose a different member.

The first signal line 22 is a signal line configured to transmit a radio-frequency signal. The first signal line 22 may be single-ended as a single signal line, or may include two signal lines, namely, a 1a-th signal line 22a and a 1b-th signal line 22b. The 1a-th signal line 22a and the 1b-th signal line 22b may be parallel to each other. The 1a-th signal line 22a and the 1b-th signal line 22b may be signal lines each configured to transmit a differential signal.

The first signal line 22 (i.e., the 1a-th signal line 22a and the 1b-th signal line 22b) may be positioned on an upper surface of the insulating substrate 21. Part of the first signal line 22 may be positioned on the upper surface of the insulating substrate 21 whereas the remaining part may be positioned inside the insulating substrate 21 or on a rear surface of the insulating substrate 21. When the frame 52 is provided, part of the first signal line 22 may be positioned inside the frame 52 (e.g., between the frame 52 and the insulating substrate 21).

The recess 24 may be positioned between the 1a-th signal line 22a and the 1b-th signal line 22b. The recess 24 may be shaped to be oblong along the signal line. The recess 24 may have an oval shape or a rectangular shape in a plan perspective view. Plan perspective view means perspectively viewing in a direction vertical to a board surface of the wiring board 20 provided with the first signal line 22. The recess 24 may be opened to the board surface. The recess 24 may have a tapered shape, an inversely tapered shape, or a stepped shape in a sectional view. The recess 24 in the tapered shape includes an open end wider than a bottom end, whereas the recess 24 in the inversely tapered shape includes the bottom end wider than the open end. The recess 24 may be distant from or in contact with the 1a-th signal line 22a and the 1b-th signal line 22b.

The ground conductor 23 may include ground film conductors 23a and 23b (see FIG. 3) positioned on respective sides of the first signal line 22 (i.e., the 1a-th signal line 22a and the 1b-th signal line 22b), a ground film conductor 23c (see FIG. 3) positioned on a bottom surface of the recess 24, a ground film conductor 23d (see FIG. 1A) expanding in a layer below the first signal line 22, a ground film conductor 23e (see FIG. 1A) expanding in a layer above the first signal line 22 inside the frame 52 when the frame 52 is provided, a ground via conductor 23v1 (see FIG. 1A) configured to provide conductivity between the ground film conductors 23a, 23b, and 23c and the ground film conductor 23d positioned in the lower layer, and a ground via conductor 23v2 (see FIG. 1A) configured to provide conductivity between the ground film conductors 23a and 23b and the ground film conductor 23e positioned in the upper layer. The ground conductor 23 may further include a ground line 23h (see FIG. 3) positioned between the 1a-th signal line 22a and the 1b-th signal line 22b, and a ground via conductor (not illustrated) configured to provide conductivity between the ground line 23h and the ground film conductor 23d or 23e positioned in the lower or upper layer.

The ground film conductors 23a and 23b may have film shapes expanding along the signal line and in the line width direction of the signal line with a clearance from the first signal line 22 (i.e., the 1a-th signal line 22a and the 1b-th signal line 22b).

The ground line 23h may be positioned between the 1a-th signal line 22a and the 1b-th signal line 22b outside a region provided with the recess 24.

### <Details of first joint region on wiring board>

As illustrated in FIGs. 1A, 1B, and 3, the wiring board 20 includes a first joint region R1 overlapped with the flexible substrate 30. The wiring board 20 may include a first edge E20 disposed at one end of the board surface and crossing an extension of the first signal line 22, and the first joint region R1 may include the first edge E20. When the frame 52 is provided, the first joint region R1 may expand to a foot of the frame 52. That is, the frame 52 and an edge of the flexible substrate 30 may be in contact with each other.

As illustrated in FIG. 3, the first joint region R1 may include part of the first signal line 22 (i.e., the 1a-th signal line 22a and the 1b-th signal line 22b), the recess 24, part of the ground film conductors 23a and 23b, and the ground film conductor 23c, which are mentioned above.

Part including line ends of the 1a-th signal line 22a and the 1b-th signal line 22b may be positioned in the first joint region R1. An end of the 1a-th signal line 22a and an end of the 1b-th signal line 22b may be spaced apart from the first edge E20. The 1a-th signal line 22a and the 1b-th signal line 22b may be exposed onto the first joint region R1.

The recess 24 may entirely be positioned in the first joint region R1.

The ground film conductors 23a and 23b may expand in the first joint region R1 from the first edge E20 to an opposite edge. That is, the ground film conductors 23a and 23b may each extend from the first edge E20 to a position overlapped with a second edge E30 of the flexible substrate 30 in a plan perspective view. In the first joint region R1, an interval between the two ground film conductors 23a and 23b positioned to interpose the first signal line 22 (specifically, an interval in the line width direction of the signal line) may be narrow near the first edge E20, wide in a center portion of the first joint region R1, and narrow at the opposite edge of the first edge E20. The ground film conductors 23a and 23b may be exposed onto the first joint region R1.

The ground film conductor 23c may be positioned on the bottom surface of the recess 24. The bottom surface of the recess 24 and the ground film conductor 23c may be covered from above with an insulating film 25. The insulating film 25 may be alumina coating. The first signal line 22 or the recess 24 may be in contact with the first edge E20. The recess 24 may be opened to an end surface of the wiring board 20. The recess 24 may be a hole penetrating from an upper surface to a lower surface of the wiring board 20.

### <Flexible substrate>

As illustrated in FIGs. 2A and 2B, the flexible substrate 30 may include an insulating base 31 having flexibility and a sheet shape. The insulating base 31 includes a first surface S1 and a second surface S2 positioned opposite to the first surface S1.

The flexible substrate 30 includes a second signal line 32 positioned on the first surface S1. The second signal line 32 may partially be joined to the first signal line 22 on the wiring board 20, and may be equal in number of lines to the first signal line 22. The second signal line 32 may therefore include two signal lines, namely, a 2a-th signal line 32a and a 2b-th signal line 32b. The 2a-th signal line 32a and the 2b-th signal line 32b may be parallel to each other. The 2a-th signal line 32a and the 2b-th signal line 32b may be signal lines each configured to transmit a differential signal. The second signal line 32 may include electrode pads 32c and 32d larger in line width larger than the remaining part. The electrode pads 32c and 32d may be shaped to be oblong along the signal line, and may be positioned at an end of the second signal line 32.

The flexible substrate 30 further includes a slit 35 disposed adjacent to the second signal line 32. The second signal line 32 and the slit 35 adjacent to each other are aligned in a line width direction of the second signal line 32, a line direction, or in a direction slanted from the line width direction. When the second signal line 32 and the slit 35 are disposed adjacent to each other, a center line in the line direction of the second signal line 32 and a center line in a longitudinal direction of the slit 35 are not necessarily parallel to each other. The slit 35 may be positioned around the second signal line 32. Being positioned around the second signal line 32 can mean being positioned close enough to influence transmission characteristics of the second signal line 32, and can mean that distance from the second signal line 32 is twice or less the line width of the second signal line 32. The slit 35 may be positioned from the first surface S1 to the second surface S2. The slit 35 may be hollow. The slit 35 may have a rectangular shape, a circular shape, an oblong shape, an elliptical shape, or the like. The slit 35 has a width that may be increased as being away from the second edge E30 or may inversely be decreased as being away from the second edge E30. The slit 35 may have a tapered shape, an inversely tapered shape, or a stepped shape in a sectional view. The tapered shape has a slanted side surface with a size at a level of the second surface S2 being larger than a size at a level of the first surface S1. The inversely tapered shape has a slanted side surface with a size at the level of the second surface S2 being smaller than a size at the level of the first surface S1. Furthermore, the slit 35 may be distant from or in contact with the second signal line 32.

The flexible substrate 30 may further include a film conductor positioned on the first surface S1 and the second surface S2, and a via conductor positioned from the first surface S1 to the second surface S2, which are to be described later.

The film conductor may include electrode film conductors 33a and 33b positioned on the second surface S2, a second ground film conductor 33e positioned on the second surface S2, and first ground film conductors 33c and 33d positioned on respective sides to interpose the second signal line 32 on the first surface S1. The electrode film conductors 33a and 33b may be positioned to face the electrode pads 32c and 32d of the second signal line 32. The second ground film conductor 33e may expand around the electrode film conductors 33a and 33b with a clearance to surround the electrode film conductors 33a and 33b from three sides. The three sides include both sides of a line width direction of a signal line and a side along the signal line.

The via conductor may include electrode via conductors 34a to 34d connecting the electrode pads 32c and 32d and the electrode film conductors 33a and 33b, and a plurality of ground via conductors (not illustrated) connecting the first ground film conductors 33c and 33d and the second ground film conductor 33e. The plurality of ground via conductors may interpose the 2a-th signal line 32a and the 2b-th signal line 32b and be aligned along the signal lines.

### <Details of second joint region on flexible substrate>

As illustrated in FIGs. 2A and 2B, the flexible substrate 30 includes a second joint region R2 overlapped with the first joint region R1 of the wiring board 20. The flexible substrate 30 may include the second edge E30 disposed at one end and crossing an extension of the second signal line 32, and the second joint region R2 may include the second edge E30.

The second joint region R2 may be provided with the electrode pads 32c and 32d of the second signal line 32, part of the first ground film conductors 33c and 33d, and the slit 35.

An opposite surface of the second joint region R2 may be provided with the electrode film conductors 33a and 33b, part of the second ground film conductor 33e, and the slit 35.

In the second joint region R2, the electrode pads 32c and 32d, the first ground film conductors 33c and 33d, the electrode film conductors 33a and 33b, and the second ground film conductor 33e may be spaced apart from the second edge E30. The slit 35 may be positioned to reach the second edge E30.

As illustrated in FIG. 2A, the electrode film conductors 33a and 33b have portions that are connected to the electrode via conductors 34a to 34d and that may be wider than the remaining portions. That is, the electrode film conductors 33a and 33b have outlines that may have uneven portions (specifically narrow concave portions and wide convex portions) N1 and N2 including portions projecting in the line width direction and portions depressed in the line width direction which are alternately aligned along the signal line.

The second ground film conductor 33e may include uneven portions N3 and N4 including portions projecting in the line width direction and portions depressed in the line width direction which are alternately aligned in portions facing the electrode film conductors 33a and 33b in the line width direction of the signal line. Each of the projecting portions may be connected to the ground via conductor. The uneven portions N1 and N2 of the electrode film conductors 33a and 33b and the uneven portions N3 and N4 of the second ground film conductor 33e may be disposed staggeredly. That is, the concave portions in the uneven portions N1 and N2 and the convex portions in the uneven portions N3 and N4 may be aligned in the line width direction, and the convex portions in the uneven portions N1 and N2 and the concave portions in the uneven portions N3 and N4 may be aligned in the line width direction.

### <Joining>

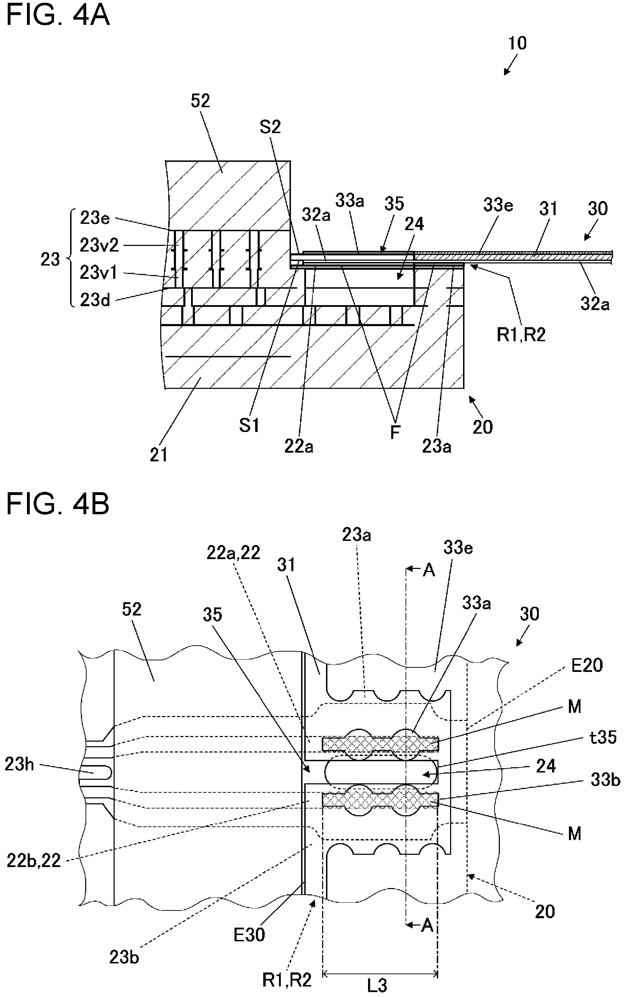

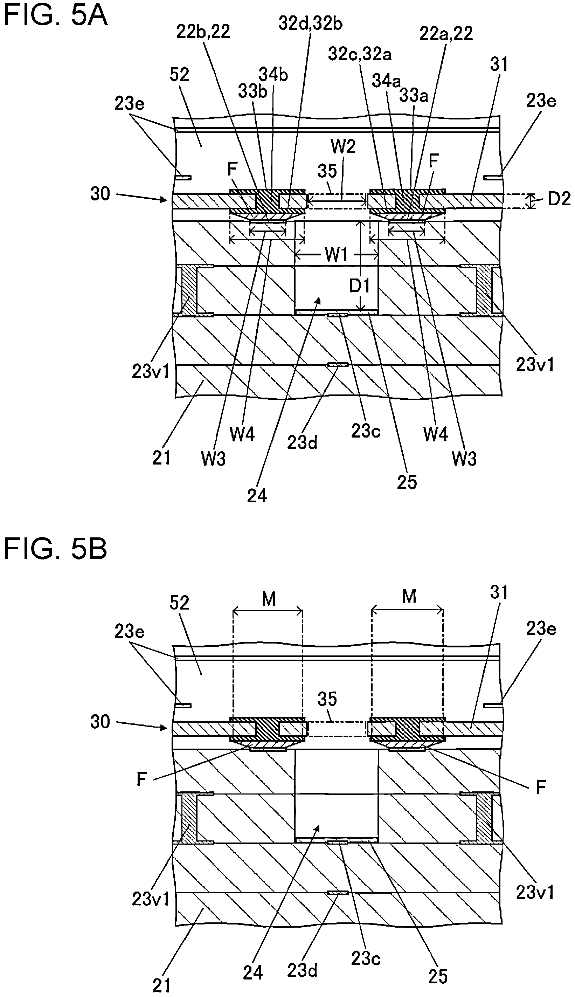

FIGs. 4A and 4B are a longitudinal sectional view and a plan view each illustrating a joint portion of the signal lines and the periphery of the joint portion. FIGs. 5A and 5B are sectional views taken along line A-A in FIG. 4B. FIGs. 5A and 5B illustrate an identical location.

The first joint region R1 of the wiring board 20 and the second joint region R2 of the flexible substrate 30 are overlapped with each other. Part of the first joint region R1 and part of the second joint region R2 may be joined to each other via a bonding material F such as a brazing filler metal having electroconductivity (see FIGs. 4A, 5A, and 5B). Specifically, the first signal line 22 in the first joint region R1 and the electrode pads 32c and 32d in the second joint region R2 may be joined to each other via the bonding material F (that is, the second signal line 32 may be joined), and the ground film conductors 23a and 23b in the first joint region R1 and the first ground film conductors 33c and 33d (see FIG. 2B) in the second joint region R2 may be joined to each other via the bonding material F.

For Joining, heat is applied to an opposite side of the second joint region R2 of the flexible substrate 30 in the state where the first joint region R1 and the second joint region R2 are overlapped with each other, to transfer heat to the bonding material F at each site via the conductors on the flexible substrate 30 and melt the bonding material F. The bonding material F is then cooled to be solidified, and the first joint region R1 and the second joint region R2 are joined to each other.

### <Details of joint portion>

As described above, the wiring board 20 includes the first signal line 22, and the recess 24 provided as a cutout and disposed adjacent to the first signal line 22. The flexible substrate 30 includes the second signal line 32, and the slit 35 disposed adjacent to the second signal line 32. The recess 24 is positioned in the first joint region R1 whereas the slit 35 is positioned in the second joint region R2 in a plan perspective view. This configuration can suppress an increase in the capacitance components (e.g., electrostatic capacitance components) around the joint portion between the first signal line 22 and the second signal line 32. That is, the joint portion is provided with the wiring board 20 and the insulating base 31 each having a high relative dielectric constant. This is likely to increase capacitance components around the first signal line 22 and the second signal line 32 and decrease characteristic impedance. However, the slit 35 thus provided can decrease a relative dielectric constant around the second signal line 32 on the insulating base 31. The joint portion can therefore have a suppressed increase in the capacitance components of the second signal line 32. Furthermore, the recess 24 thus provided can decrease a relative dielectric constant around the first signal line 22 on the insulating substrate 21. The joint portion can therefore have a suppressed increase in the capacitance components of the first signal line 22. Accordingly, the joint portion between the first signal line 22 and the second signal line 32 can have a suppressed possibility of an increase in capacitance components and improved characteristic impedance matching. The composite wiring board 10 can therefore be improved in radio-frequency signal transmission characteristics.

As described above, the slit 35 may be positioned to reach the second edge E30 of the flexible substrate 30. This configuration can further suppress an increase in the capacitance components around the second signal line 32. The joint portion between the first signal line 22 and the second signal line 32 can therefore have an efficiently suppressed increase in capacitance components. Accordingly, the joint portion can have more improved characteristic impedance matching and more improved radio-frequency signal transmission characteristics.

The second signal line 32 may include the 2a-th signal line 32a and the 2b-th signal line 32b disposed parallel to each other. As described above, and the slit 35 may be positioned between the 2a-th signal line 32a and the 2b-th signal line 32b. In this configuration, due to symmetry between the first signal line 22 and the second signal line 32, the first signal line 22 on the wiring board 20 includes the 1a-th signal line 22a and the 1b-th signal line 22b. Provision of the slit 35 as described above can achieve a suppress increase in the capacitance components between the 2a-th signal line 32a and the 2b-th signal line 32b. The joint portion between the first signal line 22 and the second signal line 32 can therefore have an efficiently suppressed increase in capacitance components and can be improved in radio-frequency signal transmission characteristics.

The recess 24 provided as a cutout and the slit 35 may be at least partially overlapped with each other in a plan perspective view (see FIG. 4B). This configuration can decrease capacitance components of the insulating substrate 21 and capacitance components of the insulating base 31 at symmetrical locations on the insulating substrate 21 and the insulating base 31. This can therefore achieve a decreased difference in characteristic impedance between the joint portion of the first signal line 22 and the second signal line 32 and locations in front of and behind the joint portion. This can therefore improve radio-frequency signal transmission characteristics. Furthermore, the recess 24 and the slit 35 are preferably overlapped with each other by 50% or more in area ratio in a plan perspective view (that is, in a plan perspective view, 50% or more of the total area of the recess 24 is overlapped with the slit 35, and 50% or more of the total area of the slit 35 is overlapped with the recess 24). Overlapping by 50% or more in area ratio can achieve a decrease in the capacitance components of the insulating substrate 21 and a decrease in the capacitance components of the insulating base 31.

The slit 35 has a size L2 (see FIG. 2B) in the direction along the signal line, and the size L2 may be larger than a size L1 (see FIG. 3) of the recess 24 in the direction. This configuration can stably secure an overlapping length between the slit 35 and the recess 24 even with any joined position error in the direction along the signal line. The joint portion can therefore have a stably suppressed increase in capacitance components and can stably be improved in radio-frequency signal transmission characteristics.

The recess 24 has a width W1 (specifically a width in the line width direction of the signal line, see FIGs. 3 and 5A) which may be larger than a width W2 of the slit 35 (specifically a width in the line width direction of the signal line, see FIGs. 2B and 5A). This configuration can suppress overlapping between part of the first signal line 22 and the slit 35 even with any joined position error in the width direction of the signal line. The first j oint region R1 can thus stably achieve a structure in which the flexible substrate 30 overlaps on the first signal line 22. This structure can suppress large individual differences in characteristic impedance. This leads to stable radio-frequency signal transmission characteristics.

The recess 24 has a thickness D1 (i.e., a length perpendicular to the board surface) which may be larger than a thickness D2 of the slit 35 (see FIG. 5A). In a case where influence on impedance matching of the composite wiring board 10 is largely caused by the capacitance components of the first signal line 22 and the thickness D1 is larger than the thickness D2, the wiring board 20 can have a further suppressed increase in capacitance components. The composite wiring board 10 can therefore achieve stable radio-frequency signal transmission characteristics. The thickness D1 of the recess 24 may exemplarily be defined as the minimum distance from the board surface to the bottom surface of the recess 24.

In the direction along the signal line, the size L2 (see FIG. 2B) of the slit 35 may be larger than a size L3 (see FIG. 4B) of a superimposed region M. The superimposed region M corresponds to a region where the first signal line 22 and the second signal line 32 are joined to each other (i.e., a region provided with the bonding material F) (see FIGs. 4B and 5B). FIG. 4B illustrates the superimposed region M by hatching. In this configuration, the joint portion is likely to have a further decrease in the capacitance components around the second signal line 32. This can therefore more efficiently decrease the capacitance components and can improve radio-frequency signal transmission characteristics.

In the superimposed region M, the 1a-th signal line 22a has a line width W3 that may be smaller than a line width W4 of the 2a-th signal line 32a (specifically the width W4 of the electrode pad 32c) (see FIG. 5A). This configuration can suppress extrusion of the 1a-th signal line 22a from the 2a-th signal line 32a (specifically the electrode pad 32c) in a plan perspective view even with any joined position error in the width direction of the signal line. The superimposed region M can thus stably achieve a structure in which the 2a-th signal line 32a (specifically the electrode pad 32c) overlaps on the 1a-th signal line 22a. This structure can suppress large individual differences in characteristic impedance. This leads to stable radio-frequency signal transmission characteristics. The line width W3 of the 1a-th signal line 22a may have the maximum size of the line width W3 of the 1a-th signal line 22a.

In the same or a similar manner, in the superimposed region M, the line width W3 of the 1b-th signal line 22b may be smaller than the line width W4 of the 2b-th signal line 32b (specifically the width W4 of the electrode pad 32d) (see FIG. 5A). This configuration can suppress extrusion of the 1b-th signal line 22b from the 2b-th signal line 32b (specifically the electrode pad 32d) in a plan perspective view even with any joined position error in the width direction of the signal line. The superimposed region M can thus stably achieve a structure in which the 2b-th signal line 32b (specifically the electrode pad 32d) overlaps on the 1b-th signal line 22b. This structure can suppress large individual differences in characteristic impedance. This leads to stable radio-frequency signal transmission characteristics.

The electrode film conductors (corresponding to first film conductors) 33a and 33b may be smaller in area than the superimposed region M (see FIG. 4B). This configuration can also allow heat to be conducted from the second surface S2 to the electrode pads 32c and 32d positioned on the first surface S1 via the electrode film conductors 33a and 33b and allow the bonding material F to be melted. Furthermore, the electrode film conductors 33a and 33b having such small areas can decrease capacitance components generated by the electrode film conductors 33a and 33b in capacitance components to be applied to the second signal line 32. Therefore, the joint portion between the first signal line 22 and the second signal line 32 can have improved characteristic impedance matching and improved radio-frequency signal transmission characteristics.

The slit 35 includes a first slit end portion t35 (see FIG. 4B) positioned far from the second edge E30 of the flexible substrate 30. In a plan perspective view, the first slit end portion t35 may be spaced apart from the first edge E20 of the first joint region R1 and positioned on the first joint region R1. This configuration can suppress curving at the first slit end portion t35, so that the slit 35 is less likely to receive stress. The flexible substrate 30 can therefore have a suppressed possibility of damage at the first slit end portion t35.

The recess 24 may be opened to the board surface of the wiring board 20. The wiring board 20 may include the insulating film 25 (see FIG. 3) positioned on the bottom surface of the recess 24. This configuration can suppress a possibility of a short circuit between the ground film conductor 23c in the recess 24 and each of the first signal line 22 and the second signal line 32 even in a case where the bonding material F joining the first signal line 22 and the second signal line 32 drops into the recess 24. The composite wiring board 10 can therefore be improved in radio-frequency signal transmission characteristics.

The second signal line 32 may be distant from the slit 35 with a clearance Q (see FIG. 2B) provided therebetween in a plan perspective view. This configuration is less likely to cause the bonding material F joining the first signal line 22 and the second signal line 32 to expand to an inner circumferential surface of the slit 35 and influence characteristic impedance at the joint portion. The composite wiring board 10 can therefore be improved in radio-frequency signal transmission characteristics.

### <Radio-frequency signal transmission characteristics>

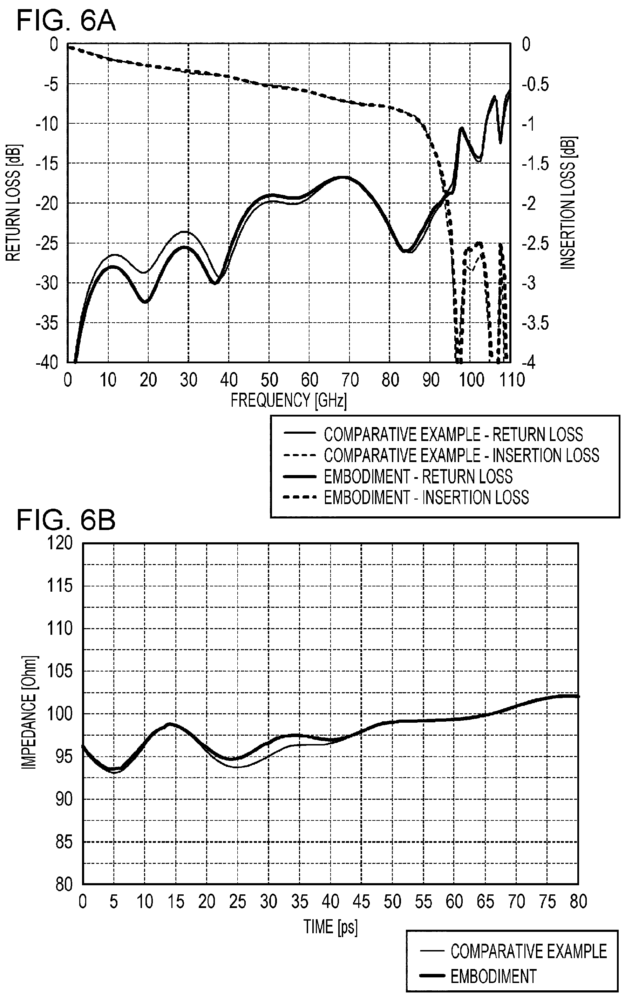

FIG. 6A is a graph indicating frequency characteristics of composite wiring boards according to embodiment 1 and a comparative example. FIG. 6B is a graph indicating impedance characteristics of the composite wiring boards according to embodiment 1 and the comparative example. The graphs indicate simulation results of the composite wiring board 10 according to the embodiment and the composite wiring board according to the comparative example. Frequency characteristics include an insertion loss and a return loss, and impedance characteristics are indicated in accordance with TDR (time domain reflectometry). Simulation adopts the composite wiring board 10 according to the embodiment including the constituent elements described above and being configured as illustrated in FIGs. 1 to 6. The composite wiring board according to the comparative example has a configuration obtained by removing the slit 35 from the configuration according to the embodiment.

FIG. 6A indicates that the return loss decreases in the range from 3 GHz to 40 GHz as well as that deterioration of insertion loss characteristics is suppressed in a high band when the recess 24 is positioned in the first joint region R1 and the slit 35 is positioned in the second joint region R2.

FIG. 6B indicates that a difference in characteristic impedance is decreased between a location around the joint portion and the location in front of the joint portion as well as between the location around the joint portion and the location behind the joint portion to improve characteristic impedance matching when the recess 24 is positioned in the first joint region R1 and the slit 35 is positioned in the second joint region R2. TDR includes a time domain from 20 ps to 40 ps indicating impedance around the joint portion.

As described above, the composite wiring board 10 according to the above embodiment can have improved characteristic impedance matching at the joint portion between the wiring board 20 and the flexible substrate 30, and can achieve improved radio-frequency signal transmission characteristics.

### (Embodiment 2)

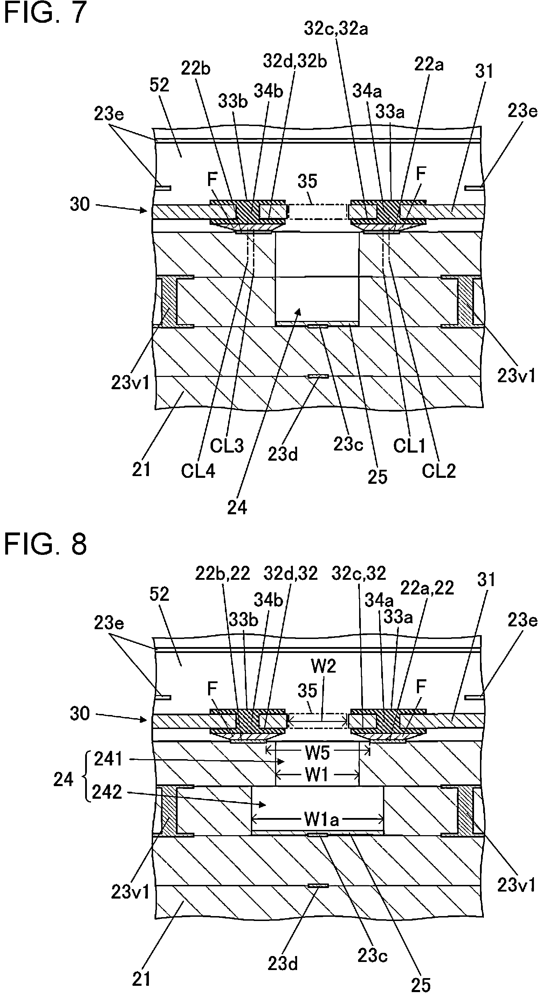

FIG. 7 is a sectional view of a composite wiring board according to embodiment 2. FIG. 7 illustrates a section positioned identically to a section illustrated in FIG. 5A. Embodiment 2 provides a composite wiring board 10 configured in the same or a similar manner to the composite wiring board according to embodiment 1 except for part of elements. Description is hereinafter made to such elements different from the elements according to embodiment 1.

In the superimposed region M (see FIGs. 4B and 5B), a center CL1 in the line width direction of the 1a-th signal line 22a may be displaced from a center CL2 in the line width direction of the 2a-th signal line 32a (specifically the electrode pad 32c) to one side in the line width direction (see FIG. 7). The center CL1 of the 1a-th signal line 22a may be displaced from the center CL2 of the 2a-th signal line 32a (specifically the electrode pad 32c) to approach the recess 24. That is, distance between the recess 24 and the center CL1 in the line width direction of the 1a-th signal line 22a may be shorter than distance between the recess 24 and the center CL2 in the line width direction of the 2a-th signal line 32a.

In the same or a similar manner, in the superimposed region M (see FIGs. 4B and 5B), a center CL3 in the line width direction of the 1b-th signal line 22b may be displaced from a center CL4 in the line width direction of the 2b-th signal line 32b (specifically the electrode pad 32d) to one side in the line width direction (see FIG. 7). The center CL3 of the 1b-th signal line 22b may be displaced from the center CL4 of the 2b-th signal line 32b (specifically the electrode pad 32c) to approach the recess 24. That is, distance between the recess 24 and the center CL3 in the line width direction of the 1b-th signal line 22b may be shorter than distance between the recess 24 and the center CL4 in the line width direction of the 2b-th signal line 32b.

The above positional relationship between the centers CL3 and CL4 can increase an area where the recess 24 and the slit 35 are overlapped with each other. The composite wiring board 10 can therefore be further improved in radio-frequency signal transmission characteristics.

### (Embodiment 3)

FIG. 8 is a sectional view of a composite wiring board according to embodiment 3. FIG. 8 illustrates a section positioned identically to the section illustrated in FIG. 5A. Embodiment 3 provides a composite wiring board 10 configured in the same or a similar manner to the composite wiring board according to embodiment 1 except for part of elements. Description is hereinafter made to such elements different from the elements according to embodiment 1.

The recess 24 may include an upper layer portion 241 and a lower layer portion 242, and the upper layer portion 241 and the lower layer portion 242 may be disposed vertically continuously. The upper layer portion 241 has a width W1 (specifically a width in the line width direction of the signal line) which may be different from a width W1a (specifically a width in the line width direction of the signal line) of the lower layer portion 242. For example, the width W1a > the width W1 may be established. That is, the width W1a may be larger than the width W1.

Furthermore, the width W1 of the upper layer portion 241 < an interval W5 between the 1a-th signal line 22a and the 1b-th signal line 22b < the width W1a of the lower layer portion 242 may be established. That is, the width W1 of the upper layer portion 241 may be smaller than the interval W5, and the width W1a of the lower layer portion 242 may be larger than the interval W5. The interval W5 is distance between the 1a-th signal line 22a and the 1b-th signal line 22b.

Furthermore, the width W1 of the upper layer portion 241 may be larger than the width W2 of the slit 35, and the width W2 of the lower layer portion 242 may be larger than the width W2 of the slit 35.

A center in a width direction of the upper layer portion 241 may be overlapped with a center in a width direction of the lower layer portion 242 in a plan perspective view.

The insulating substrate 21 may have a stacked structure including a plurality of stacked dielectric layers. In this case, the upper layer portion 241 of the recess 24 may be positioned in an n-th dielectric layer of the insulating substrate 21, and the lower layer portion 242 of the recess 24 may be positioned in an (n+1)-th dielectric layer of the insulating substrate 21.

In the above configuration, the width W1 of the upper layer portion 241 is limited by the 1a-th signal line 22a and the 1b-th signal line 22b, whereas the width W1a of the lower layer portion 242 can be increased without such limitation. The large width W1a of the lower layer portion 242 can further decrease the relative dielectric constant around the first signal line 22 on the insulating substrate 21. The joint portion can thus have a further suppressed increase in the capacitance components of the first signal line 22. Accordingly, the joint portion between the first signal line 22 and the second signal line 32 can have a suppressed increase in capacitance components and improved characteristic impedance matching. The composite wiring board 10 can therefore be improved in radio-frequency signal transmission characteristics.

### (Embodiment 4)

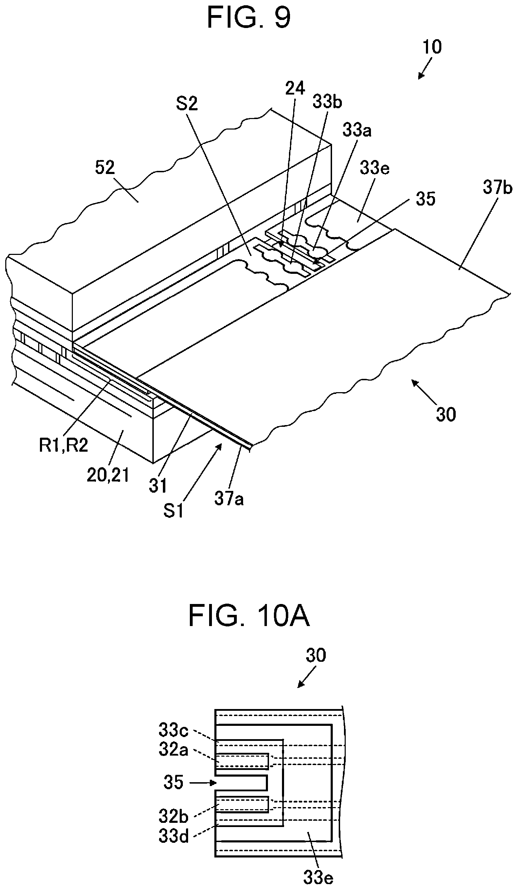

FIG. 9 is a perspective view of a composite wiring board according to embodiment 4. Embodiment 4 provides a composite wiring board 10 configured in the same or a similar manner to the composite wiring board according to embodiment 1 except for part of elements. Description is hereinafter made to such elements different from the elements according to embodiment 1.

As illustrated in FIG. 9, the flexible substrate 30 may include a protective film 37a covering to protect part of the second signal line 32 (corresponding to a conductor layer) and part of the first ground film conductors 33c and 33d (corresponding to conductor layers) on the first surface S1. The flexible substrate 30 may further include a protective film 37b covering to protect part of the second ground film conductor 33e (corresponding to a conductor layer) on the second surface S2. Each of the protective films 37a and 37b may also be called a cover lay.

The protective film 37a on the first surface S1 may be positioned outside the first joint region R1. The protective film 37a is not necessarily overlapped with the slit 35 in a plan perspective view.

The protective film 37b on the second surface S2 may be positioned in a region excluding the electrode film conductors 33a and 33b conducted with the second signal line 32 and a range aligned with the electrode film conductors 33a and 33b in the second ground film conductor 33e (specifically a range aligned in the line width direction of the signal line). The protective film 37b is not necessarily overlapped with the slit 35.

In the composite wiring board 10 according to embodiment 4, the protective films 37a and 37b can protect the conductors on the first surface S1 and the conductors on the second surface S2 of the flexible substrate 30, and can suppress a short circuit and the like of the conductors. The protective films 37a and 37b can further enhance strength of the flexible substrate 30. Moreover, the slit 35 is not overlapped with the protective films 37a and 37b. This can suppress influence of the protective films 37a and 37b on an action by the slit 35 of improving specific impedance matching.

### (Slit according to variations)

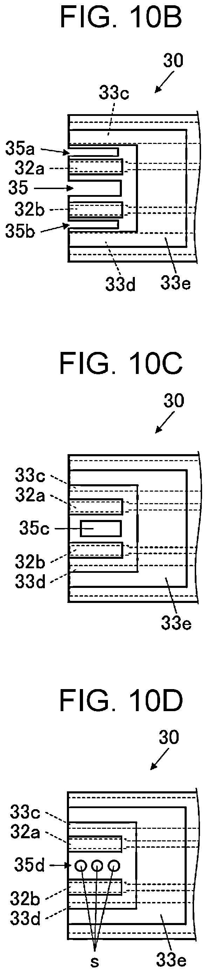

FIG. 10A illustrates the slit according to embodiments 1 to 4. FIGs. 10B to 10G illustrate slits according to variations 1 to 6, respectively. The slit 35 in the flexible substrate 30 is not limited to the configuration illustrated in FIG. 10A. The width W2 and the length L2 of the slit 35 are not necessarily constant, and can be properly set for adjustment to appropriate impedance.

As illustrated in FIG. 10B, the flexible substrate 30 may include, in addition to the slit 35, a slit 35a disposed between the 2a-th signal line 32a and the first ground film conductor 33c, and a slit 35b disposed between the 2b-th signal line 32b and the first ground film conductor 33d. The slits 35a and 35b may be oblong along the signal line, and may be aligned with the 2a-th signal line 32a and the 2b-th signal line 32b in the line width direction of the signal line. This configuration additionally provided with the slits 35a and 35b can further suppress an increase in the capacitance components around the joint portion caused by the insulating base 31 of the flexible substrate 30. The slit 35, the slits 35a, and the slit 35b may all be equal or different in width and length. For example, the slit 35 may be larger in width than at least one of the slits 35a and 35b in an embodiment.

As illustrated in FIG. 10C, the flexible substrate 30 may include a slit 35c spaced apart from the second edge E30. This configuration can decrease the capacitance components around the joint portion and can keep the strength of the flexible substrate 30.

As illustrated in FIG. 10D, the flexible substrate 30 may include a slit 35d including a plurality of sub-slits s divided from each other in the direction along the signal line. This configuration can keep the strength of the flexible substrate 30 and can cause the slit 35d to suppress an increase in the capacitance components of the insulating base 31 around the joint portion. The sub-slits s can have any proper shape appropriately selected from a rectangular shape, a square shape, a circular shape, and the like in accordance with design conditions.

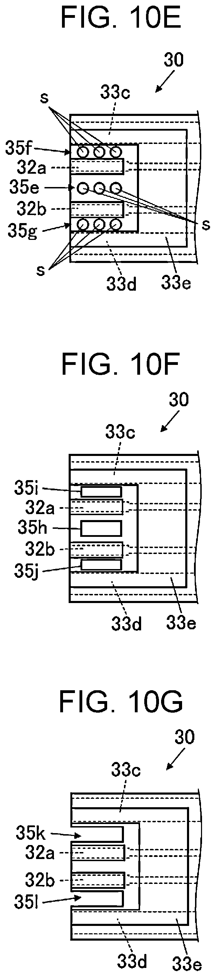

As illustrated in FIG. 10E, the flexible substrate 30 may include a plurality of slits 35e, 35f, and 35g each of which may include a plurality of sub-slits s divided from each other in the direction along the signal line. The slits 35e, 35f, and 35g may be disposed at the same or similar positions of the slits 35, 35a, and 35b illustrated in FIG. 10B. This configuration can keep the strength of the flexible substrate 30 and can further suppress an increase in the capacitance components of the insulating base 31.

As illustrated in FIG. 10F, the flexible substrate 30 may include a slit 35h positioned between the 2a-th signal line 32a and the first ground film conductor 33c and spaced apart from the second edge E30. In the same or a similar manner, the flexible substrate 30 may include a slit 35i positioned between the 2b-th signal line 32b and the first ground film conductor 33d and spaced apart from the second edge E30. In the same or a similar manner, the flexible substrate 30 may include a slit 35j positioned between the 2a-th signal line 32a and the 2b-th signal line 32b and spaced apart from the second edge E30. This configuration can keep the strength of the flexible substrate 30 and can further suppress an increase in the capacitance components due to the insulating base 31.

As illustrated in FIG. 10G, the flexible substrate 30 may include two slits 35k and 35l positioned between the 2a-th signal line 32a and the first ground film conductor 33c and between the 2b-th signal line 32b and the first ground film conductor 33d, and may include no slit between the 2a-th signal line 32a and the 2b-th signal line 32b. This configuration can cause the slits 35k and 351 to suppress an increase in the capacitance components of the insulating base 31 around the joint portion even when the 2a-th signal line 32a and the 2b-th signal line 32b interpose a narrow interval.

The recess 24 provided as a cutout in the wiring board 20 may include the single recess 24 or a plurality of recesses 24 disposed to face the slits 35b to 35l illustrated in FIGs. 10B to 10G. That is, the recesses 24 may be positioned between the 1a-th signal line 22a and the 1b-th signal line 22b, between the 1a-th signal line 22a and the ground film conductor 23a, and between the 1b-th signal line 22b and the ground film conductor 23b. Alternatively, the recesses 24 may be positioned between the 1a-th signal line 22a and the ground film conductor 23a and between the 1b-th signal line 22b and the ground film conductor 23b, and are not necessarily positioned between the 1a-th signal line 22a and the 1b-th signal line 22b.

Furthermore, the composite wiring board 10 according to the present embodiment may include the wiring board 20 that includes the recess 24 disposed at any one of the positions described above, and the flexible substrate 30 that includes the slit 35 disposed at any one of the positions described above and is joined to the wiring board 20. The recess 24 and the slit 35 may be positioned not to face each other.

### (Cutout according to variations)

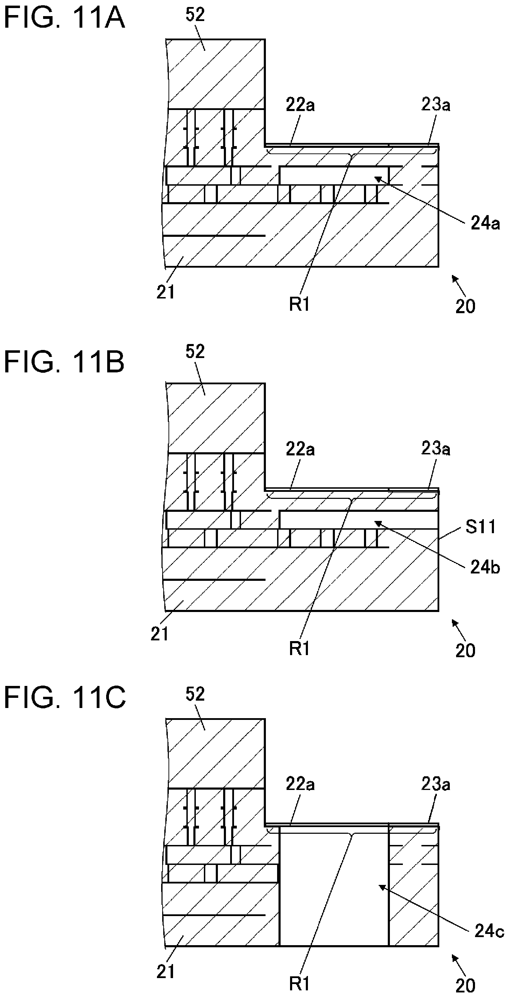

FIGs. 11A to 11C are longitudinal sectional views of cutouts according to variations 7 to 9 disposed in a wiring board, respectively. FIGs. 11A, 11B, and 11C each illustrate a section of the wiring board 20 taken at a location provided with the cutout. The above embodiment exemplifies the recess 24 as a cutout in the wiring board 20. As illustrated in FIG. 11A, the recess 24 may be replaced with a cutout 24a disposed inside the board. The cutout 24a is positioned inside the wiring board 20 to be apart from the board surface and is unopened to the board surface or the end surface of the board. In a plan perspective view, the cutout 24a may be shaped identically or similarly to the recess 24 and may be positioned identically or similarly to the recess 24.

As illustrated in FIG. 11B, the recess 24 may be replaced with a cutout 24b unopened to the board surface and opened to an end surface S11 of the board. In a plan perspective view, the cutout 24b may be shaped identically or similarly to the recess 24 and may be positioned identically or similarly to the recess 24 except for being positioned to reach the first edge E20 in the first joint region R1.

The cutout 24a or 24b thus provided can suppress a possibility that the bonding material F drops into the cutout. Furthermore, provision of the cutout 24a or 24b can also achieve a suppressed increase in the capacitance components around the joint portion between the first signal line 22 and the second signal line 32.

As illustrated in FIG. 11C, the recess 24 may be replaced with a cutout 24c penetrating from the board surface to the opposite surface of the wiring board 20. In a plan perspective view, the cutout 24c may be shaped identically or similarly to the recess 24 and may be positioned identically or similarly to the recess 24. Provision of the cutout 24c can achieve a further decrease in the capacitance components of the insulating substrate 21 around the first signal line 22. Accordingly, this can further suppress a decrease in the impedance at the joint portion between the first signal line 22 and the second signal line 32.

### (Electronic component accommodating package and electronic device)

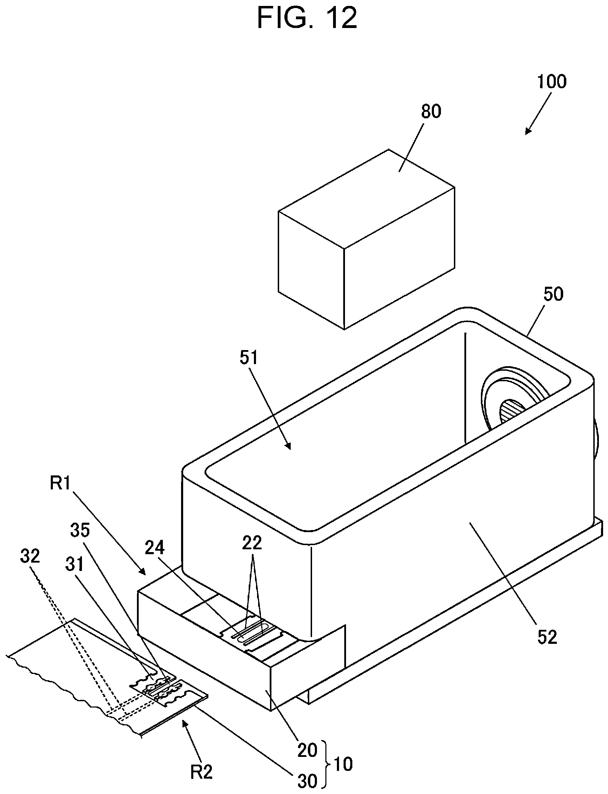

FIG. 12 is a perspective view of an electronic component accommodating package and an electronic device according to an embodiment of the present disclosure.

The present embodiment provides an electronic component accommodating package 50 including the composite wiring board 10 and the frame 52 integrated with the wiring board 20. The frame 52 surrounds an accommodating portion 51 of an electronic component 80. The frame 52 may further cover a bottom of the accommodating portion 51 and have an open top. Such an opening may be blocked by joining a lid (not illustrated).

The first joint region R1 of the wiring board 20 may be positioned outside the frame 52.

FIG. 12 illustrates the composite wiring board 10 and the electronic component accommodating package 50 that include a set of the first signal line 22 and the second signal line 32. The composite wiring board 10 and the electronic component accommodating package 50 may alternatively include a plural sets of first signal lines 22 and second signal lines 32. The plural sets of the first signal lines 22 and the second signal line 32 may be aligned in an identical direction or may be positioned at a plurality of locations and directed differently.

The present embodiment provides an electronic device 100 including electronic component accommodating package 50, and the electronic component 80 accommodated in the accommodating portion 51. The first signal line 22 on the wiring board 20 may be positioned from outside the frame 52 to inside the frame 52 and may be electrically connected to the electronic component 80 in the accommodating portion 51 via a bonding member (e.g., a brazing filler metal, a linear conductor, or a belt-shaped conductor). The electronic component 80 may be any element such as an element configured to receive a radio-frequency band electrical signal and output light, an element configured to receive an optical signal and output a radio-frequency band electrical signal, or an element configured to receive or output a radio-frequency band electrical signal.

### (Electronic component accommodating package according to different example)

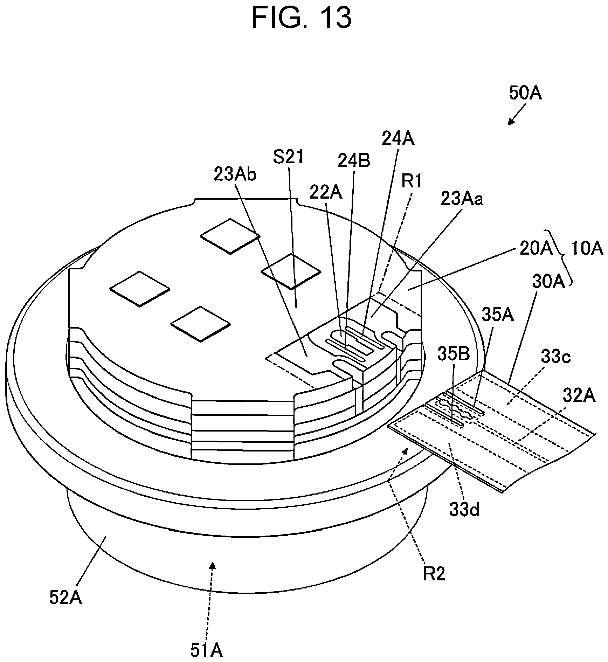

FIG. 13 is a perspective view of another exemplary electronic component accommodating package according to an embodiment of the present disclosure. FIG. 13 is a perspective view of a rear surface of an electronic component accommodating package 50A.

The electronic component accommodating package 50A has a structure of a TO (transistor outline) package type (e.g., a TO-CAN type), which includes an accommodating portion 51A configured to accommodate an electronic component and disposed on an upper surface (i.e., a lower side in FIG. 13) of a wiring board 20A, and a frame 52A joined to an upper end of the wiring board 20A (i.e., a lower end in FIG. 13) so as to cover the accommodating portion 51A. That is, the electronic component accommodating package 50A includes a composite wiring board 10A including the wiring board 20A and a flexible substrate 30A, and the frame 52A. In this case, the frame 52A may be a metal member, a ceramic member, or the like. The wiring board 20A and the frame 52A may be formed integrally with each other, or may be formed separately and then joined to each other. The wiring board 20A and the frame 52A may be both made of a material containing a ceramic and be burned integrally.

The wiring board 20A includes a lower surface S21 provided with a first signal line 22A and the first joint region R1. The second joint region R2 of the flexible substrate 30A is joined to the first joint region R1.

The first signal line 22A is positioned on the lower surface S21 of the wiring board 20A and from the lower surface S21 to the upper surface. The first signal line 22A is joined to a second signal line 32A of the flexible substrate 30A on the lower surface S21, and is electrically connected to the electronic component on the upper surface.

As exemplarily illustrated in FIG. 13, the first signal line 22A on the wiring board 20A may be a single-ended signal line, and recesses 24A and 24B provided as cutouts may be positioned on respective sides in a line width direction of the first signal line 22A, specifically, between the first signal line 22A and a first ground film conductor 23Aa and between the first signal line 22A and a second ground film conductor 23Ab. The first ground film conductor 23Aa and the second ground film conductor 23Ab are positioned on respective sides of the first signal line 22A to interpose the first signal line 22A.

The second signal line 32A on the flexible substrate 30A is a single-ended signal line, and slits 35A and 35B are positioned on respective sides in a line width direction of the second signal line 32A, specifically, between the second signal line 32A and the first ground film conductors 33c and 33d.

The electronic component accommodating package 50 or 50A and the electronic device 100 according to the present embodiment include the composite wiring board 10 or 10A according to the embodiment to improve radio-frequency signal transmission characteristics.

The embodiments of the present disclosure have been described above. However, the composite wiring board, an electronic element accommodating package, and the electronic device according to the present disclosure are not limited to the above embodiments, and can be appropriately changed without departing from the purport of the present disclosure. The embodiments, the variations, and characterized portions may be combined variously without being limited to the above exemplifications. Furthermore, combination is applicable among the embodiments, among the variations, and among the characterized portions.

### INDUSTRIAL APPLICABILITY

The present disclosure is applicable to a composite wiring board, an electronic component accommodating package, and an electronic device.

### REFERENCE SIGNS

10 composite wiring board
20, 20A wiring board
21 insulating substrate
22, 22A first signal line
22a 1a-th signal line
22b 1b-th signal line
23 ground conductor
23 a to 23 e ground film conductor
23Aa first ground film conductor
23Ab second ground film conductor
23h ground line
23v1 ground via conductor
23v2 ground via conductor
24 recess
24a cutout
24b cutout
24A recess
24B recess
25 insulating film
30, 30A flexible substrate
31 insulating base
32, 32A second signal line
32a 2a-th signal line
32b 2b-th signal line
32c, 32d electrode pad
33a, 33b electrode film conductor (first film conductor)
33c, 33d first ground film conductor
33e second ground film conductor
34a to 34d electrode via conductor
35, 35a to 35l, 35A, 35B slit
s sub-slit
37a, 37b protective film
50, 50A electronic component accommodating package
51, 51A accommodating portion
52, 52A frame
80 electronic component
100 electronic device
M superimposed region
Q clearance
R1 first j oint region
E20 first edge
R2 second j oint region
E30 second edge
S1 first surface
S2 second surface
t35 first slit end portion

## Claims

1. A composite wiring board comprising:
a wiring board including a first joint region; and
a flexible substrate including a second joint region overlapped with the first joint region; wherein
the wiring board includes
a first signal line, and
a cutout disposed adjacent to the first signal line,
the flexible substrate includes
a second signal line to be joined to the first signal line, and
a slit disposed adjacent to the second signal line,
the cutout is positioned in the first joint region in a plan perspective view, and
the slit is positioned in the second joint region in a plan perspective view.

2. The composite wiring board according to claim 1, wherein
the slit is positioned to reach an end portion of the flexible substrate.

3. The composite wiring board according to claim 1, wherein
the slit is spaced apart from an end portion of the flexible substrate.

4. The composite wiring board according to any one of claims 1 to 3, wherein
the first signal line is a single-ended signal line,
the wiring board includes a first ground film conductor positioned on one side of the first signal line and a second ground film conductor positioned on an other side to interpose the first signal line, and
in a plan perspective view, the cutout is positioned each between the first signal line and the first ground film conductor and between the first signal line and the second ground film conductor.

5. The composite wiring board according to any one of claims 1 to 4, wherein
the second signal line includes a 2a-th signal line and a 2b-th signal line disposed parallel to each other, and
the slit is positioned between the 2a-th signal line and the 2b-th signal line, or on each side of the 2a-th signal line and the 2b-th signal line.

6. The composite wiring board according to any one of claims 1 to 5, wherein
the slit includes a plurality of sub-slits divided from each other.

7. The composite wiring board according to any one of claims 1 to 6, wherein
the cutout and the slit are at least partially overlapped with each other in a plan perspective view.

8. The composite wiring board according to claim 7, wherein
a size of the slit in a direction along the second signal line is larger than a size of the cutout in a direction along the first signal line.

9. The composite wiring board according to claim 7 or 8, wherein
a width of the cutout in a line width direction of the first signal line is larger than a width of the slit in a line width direction of the second signal line.

10. The composite wiring board according to any one of claims 1 to 9, wherein
the cutout is thicker than the slit.

11. The composite wiring board according to any one of claims 1 to 10, the composite wiring board comprising a superimposed region where the first signal line and the second signal line are overlapped and joined to each other, wherein
the slit is larger in size than the superimposed region in a direction along the first signal line.

12. The composite wiring board according to claim 11, wherein
the flexible substrate includes a first surface including the second signal line, a second surface disposed opposite to the first surface, and a first film conductor positioned on the second surface and conducted with the second signal line, and
the first film conductor is smaller in area than the superimposed region in a plan perspective view.

13. The composite wiring board according to any one of claims 1 to 12, the composite wiring board comprising a superimposed region where the first signal line and the second signal line are overlapped and joined to each other, wherein
the second signal line is larger in line width than the first signal line in the superimposed region.

14. The composite wiring board according to any one of claims 1 to 13, the composite wiring board comprising a superimposed region where the first signal line and the second signal line are overlapped and joined to each other, wherein
a center in a line width direction of the first signal line is displaced from a center in a line width direction of the second signal line to one side in the line width direction in the superimposed region.

15. The composite wiring board according to any one of claims 1 to 14, wherein
the first joint region includes a first edge of a board surface of the wiring board,
the slit includes a first slit end portion disposed far from an end portion of the flexible substrate, and
in a plan perspective view, the first slit end portion of the slit is spaced apart from the first edge and is positioned on the first joint region.

16. The composite wiring board according to any one of claims 1 to 15, wherein
the cutout is a recess opened to a board surface of the wiring board, and
the wiring board includes an insulating film positioned on a bottom surface of the recess.

17. The composite wiring board according to claim 16, the composite wiring board comprising
a ground film conductor positioned on the bottom surface of the recess, wherein
the insulating film covers the ground film conductor.

18. The composite wiring board according to any one of claims 1 to 17, wherein
the flexible substrate includes a conductor layer and a protective film covering the conductor layer, and
the slit and the protective film are spaced apart from each other in a plan perspective view.

19. The composite wiring board according to any one of claims 1 to 18, wherein
the cutout is disposed inside the wiring board to be apart from a board surface of the wiring board.

20. The composite wiring board according to any one of claims 1 to 19, wherein
the cutout penetrates from a board surface to an opposite surface of the wiring board.

21. The composite wiring board according to any one of claims 1 to 20, wherein
the second signal line and the slit interpose a clearance in a plan perspective view.

22. An electronic component accommodating package comprising:
the composite wiring board according to any one of claims 1 to 21; and
a frame integrated with the wiring board.

23. An electronic device comprising:
the electronic component accommodating package according to claim 22; and
an electronic component positioned inside the frame.
